# EUROPEAN PATENT APPLICATION

(11) **EP 2 091 090 A2**
(43) Date of publication of application: **19.08.2009**
(21) Application number: 08171563.3
(22) Date of filing: 12.12.2008
(51) Int. Cl.: H01L 31/18

(54) **Sheets of semiconductor material and methods for fabricating the same**

(30) Priority: 14.02.2008 US 31318
(71) Applicant: General Electric Company, Schenectady, NY 12345 (US)
(72) Inventor: Jonczyk, Ralf, Wilmington, DE 19808 (US)
(74) Representative: Bedford, Grant Richard

(57) **Abstract**

A sheet of semiconductor material (28) is provided, including a lower surface and an upper surface. The sheet of semiconductor material is fabricated by a process including forming a first layer (32) of silicon powder (34) that has a lower surface (36) and an opposite upper surface (38), depositing a second layer (40) across the upper surface of the first layer, wherein the second layer of silicon powder (42) has a lower surface (44) and an opposite upper surface (46) and has a substantially similar melting point to the first layer of silicon powder, and heating at least one of the first and second layers of silicon powder to initiate a controlled melt of one of the first and second layer of silicon powder and to initiate crystallization (43) of at least one of the first and second layers of silicon powder.

## Description

The field of the invention relates generally to semiconductor sheets, and more specifically to semiconductor sheets and methods of fabricating the same.

It is known to cut sheets of semiconductor material into wafers of predetermined sizes. Wafers formed of semiconductor materials are used for a variety of applications. For example, at least some known solar-electric systems employ a semiconductor substrate, typically fabricated from silicon. The use of solar-electric systems has increased sharply in the past decade, and as such, the need for semiconductor wafers has also increased in the past decade. Although the expression "solar-electric" is used herein, persons of skill in the art will recognize that the discussion applies to a variety of photovoltaic materials, and systems.

A wide variety of fabrication methods are used to produce semiconductor wafers from silicon feedstock. For example, at least some known multicrystalline silicon wafers used in solar cells are produced by melting a high-purity polycrystalline silicon material to which a dopant, such as phosphorus, boron, gallium, and/or antimony is added, has been added, in an inert atmosphere. The resulting silicon melt is cooled to form a multicrystalline ingot. The ingot is then sliced to a desired wafer size. In another fabrication method, a layer of granular silicon is applied to a belt or a setter. The silicon, along with the belt or setter, is then subjected to a thermal sequence to form a sheet of silicon. The sheet of silicon is then removed from the belt or setter, and is then sized by sawing or scribing.

A significant portion of the cost of such semiconductor wafers is the raw semiconductor material itself. For example, in the case of solar-electric systems, a limiting factor for the use of such systems may be the cost of the semiconductor material used in the wafers (in particular, the cost of high-grade silicon). Various purities of silicon feedstock are available for use in producing semiconductor wafers.

The purity of silicon feedstock is determined by the level of impurities, such as boron, phosphorous, iron, titanium, and tungsten, that are present in the silicon feedstock. Some applications of semiconductor wafers, such as high power electronic devices, require a higher degree of silicon feedstock purity than other applications, for example, solar-electric systems. Because the cost of silicon feedstock increases as the purity of the silicon feedstock increases, use of solar-electric systems may be limited by the cost of the silicon.

In one aspect according to the present invention, a method of manufacturing a sheet of semiconductor material is provided. The method includes forming a first layer of silicon powder of at least one semiconductor material, wherein the first layer has a lower surface and an opposite upper surface. The method further includes depositing a second layer across the upper surface of the first layer, wherein the second layer of silicon powder has a melting point that is substantially similar to the melting point of the first layer of silicon powder. The method also includes heating at least one of the first and second layers of silicon powder to initiate a controlled melt of one of the first and second layer of silicon powder and to initiate crystallization of at least one of the first and second layers of silicon powder.

In another aspect, a method of fabricating a semiconductor wafer is provided. The method includes forming a first layer of silicon powder that has a lower surface and an opposite upper surface. The method also includes depositing a second layer across the upper surface of the first layer, wherein the second layer of silicon powder has a lower surface and an opposite upper surface and has a substantially similar melting point to the first layer of silicon powder. The method further includes heating at least one of the first and second layers of silicon powder to initiate a controlled melt of one of the first and second layer of silicon powder and to initiate crystallization of at least one of the first and second layers of silicon powder.

In a further aspect, a sheet of semiconductor material comprising a lower surface and an upper surface is provided. The sheet of semiconductor material is fabricated by a process including forming a first layer of silicon powder that has a lower surface and an opposite upper surface, depositing a second layer across the upper surface of the first layer, wherein the second layer of silicon powder has a lower surface and an opposite upper surface and has a substantially similar melting point to the first layer of silicon powder, and heating at least one of the first and second layers of silicon powder to initiate a controlled melt of one of the first and second layer of silicon powder and to initiate crystallization of at least one of the first and second layers of silicon powder.

Various aspects and embodiments of the present invention will now be described in connection with the accompanying drawings, in which:
Figure 1 is a schematic diagram of an exemplary furnace apparatus that may be used to fabricated a semiconductor sheet; and
Figures 2-6 are cross-sectional views of a sheet of silicon during subsequent stages of fabrication using the apparatus shown in Figure 1.

Currently, silicon is one of the most commonly used semiconductor materials, also referred to as feedstock, used in the fabrication of semiconductor wafers. Accordingly, as used herein, the terms "semiconductor" and "semiconductor materials" refer to silicon-based components and silicon materials. However, as will be readily appreciated by one of ordinary skill in the art, other semiconductor materials in addition to the silicon materials and/or including non-silicon materials can be fabricated using the apparatus and methods described herein. Also, although only the use of silicon powder feedstock is described for use in fabricating a silicon sheet is described herein, a sheet of silicon feedstock may be used without deviating from the present invention.

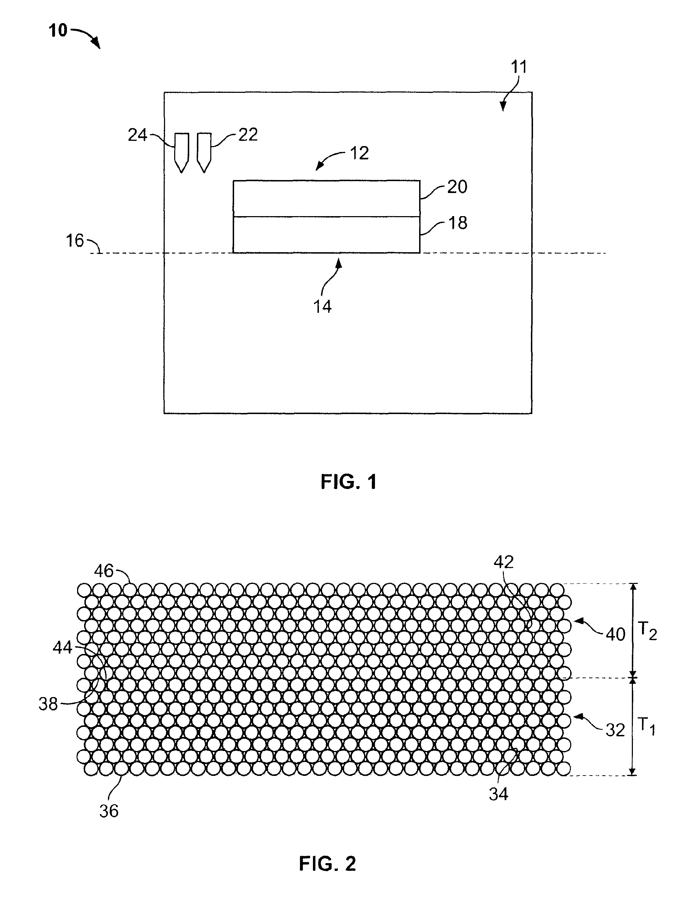

Figure 1 is a schematic diagram of an exemplary embodiment of a furnace apparatus 10 that may be used to fabricate silicon sheets (not shown in Figure 1). Furnace apparatus 10 includes a controlled atmosphere 11 that facilitates preventing inert materials from escaping furnace apparatus 10 and preventing contaminants from entering furnace apparatus 10. Controlled atmosphere 11 contains an upper climate zone 12 and a lower climate zone 14. Zones 12 and 14 may be independently controlled and operated at different temperatures. Furnace apparatus 10 also includes a surface 16 that extends between upper climate zone 12 and lower climate zone 14. Surface 16 may be a plate, a conveyor belt, a setter, and/or any other component that facilitates the fabrication of a silicon sheet as described herein.

In an exemplary embodiment, a first hopper 22 deposits a desired quantity of silicon powder together with any desired additives onto surface 16, creating a first layer 18. A second hopper 24 deposits a second layer of silicon powder onto surface 16, creating a second layer 20. Alternatively, only first hopper 22 deposits the desired quantity of silicon powder together with any desired additives onto surface 16.

In the exemplary embodiment, upper climate zone 12 and lower climate zone 14 each include a heat source (not shown in Figure 1). Each heat source provides thermal energy to each respective climate zone 12 and 14. Any heat source may be used that enables furnace apparatus 10 to function as described herein. Alternatively, upper climate zone 12 and lower climate zone 14 may also include a heat extractor (not shown). The heat extractor facilitates removing thermal energy from an object positioned within zones 12 and/or 14.

Silicon layers 18 and 20 are subjected to a thermal treatment within zones 12 and 14. In the exemplary embodiment, since upper climate zone 12 and lower climate zone 14 can be independently controlled, silicon layer 18 and/or 20 can be subjected to an independent thermal treatment such that any desired thermal profile, as described in more detail below, can be implemented.

The methods described below are performed within furnace apparatus 10 to fabricate a silicon sheet from silicon feedstock. Climate zones 12 and 14 facilitate greater control over the thermal energy applied to silicon layers 18 and/or 20. In an exemplary embodiment, silicon layer 20 experiences a higher magnitude of thermal energy than silicon layer 18. After melting some or all of layers 18, 20, it is advantageous to extract thermal energy from silicon layer 20 while applying thermal energy to silicon layer 18. In an alternative embodiment, the magnitude of thermal energy applied to silicon layer 18 is substantially the same as the magnitude of thermal energy applied to silicon layer 20. Furnace apparatus 10, and more specifically, climate zones 12 and 14, facilitate control over the application of thermal energy to silicon layers 18 and/or 20.

Figures 2-6 are cross-sectional views of semiconductor materials, for example, silicon feedstock, at subsequent stages of fabrication when fabricating a silicon sheet 28. More specifically, Figure 2 is a cross-sectional view of a first layer 32 and a second layer 40 composed of differing silicon powders. In the exemplary embodiment, a quantity of silicon powder 34 is deposited onto surface 16 (shown in Figure 1), creating a first layer 32. Once deposited, first layer 32 includes a bottom surface 36 and an upper surface 38. Subsequently, a second quantity of silicon powder 42 is deposited across first layer upper surface 38, creating a second layer 40. Once deposited, second layer 40 includes a bottom surface 44 and an upper surface 46. Alternatively, sheet 28 may include additional layers of silicon deposited on first layer 32 and/or second layer 40.

In the exemplary embodiment, layer 32 includes a thickness T₁ substantially equivalent to a thickness T₂ of layer 40. In another embodiment, T₂ is a different thickness than T₁. Alternatively, layers 32 and 40 may each have any suitable thickness that facilitates fabrication of sheet 28.

In the exemplary embodiment, first silicon powder 34 and second silicon powder 42 are different grades of silicon. For example, first silicon powder 34 is a solar-grade silicon powder that contains high levels of impurities. Specifically, silicon powder 34 contains a high percentage of boron and/or phosphorous. More specifically, the concentration of boron in silicon powder 34 is greater than about 0.5 parts per million (ppm) by weight. In an alternative embodiment, the concentration of boron in silicon powder 34 ranges from about 1 ppm by weight to about 8 ppm by weight. The concentration of phosphorous in silicon powder 34 ranges from about 1 ppm by weight to about 25 ppm by weight. Alternatively, silicon powder 34 may include any concentration of impurity that enables silicon sheet 28 to be manufactured as described herein.

Second silicon powder 42 consists of a solar-grade silicon powder containing low levels of impurities. Specifically, silicon powder 42 contains low levels of boron. More specifically, silicon powder 42 contains less than about 100 parts per billion by weight of boron. The lower concentration of boron in silicon powder 42, as compared to the concentration of boron and/or phosphorous in silicon powder 34, ensures a higher purity of second layer 40 when compared to first layer 32.

In the exemplary embodiment, silicon powders 34 and 42 have substantially equivalent melting points. More specifically, in the exemplary embodiment, powders 34 and 42 each have a melting point of about 1415° Celsius. Second layer 40 is melted into a liquid by climate zone 12 and begins to re-crystallize as first layer 32 is liquefied, as described in detail below. In an alternative embodiment, powders 34 and 42 are melted substantially simultaneously using a single climate zone 12 or 14.

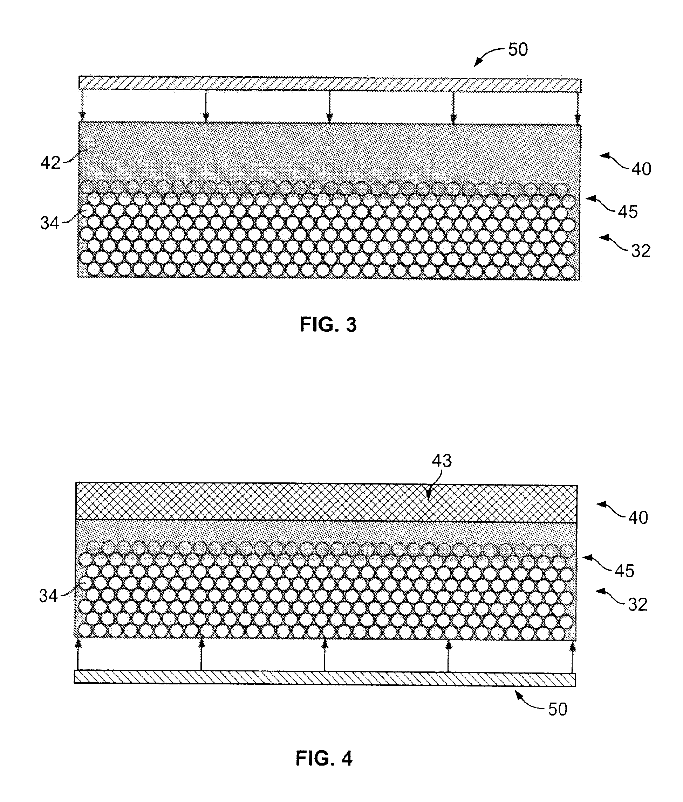

Figure 3 is a cross-sectional diagram of first layer 32 and second layer 40 during a subsequent stage of fabrication in which thermal energy 50 is applied. In the exemplary embodiment, first and second layers 32 and 40 are heated and/or cooled within furnace apparatus 10 (shown in Figure 1). In the exemplary embodiment, applying thermal energy 50 within zone 12 to second layer upper surface 46 causes second powder 42 to melt. Specifically, silicon powder 42 begins to liquefy as the temperature of zone 12 approaches, or exceeds, approximately 1415° Celsius. As second powder 42 begins to melt, the liquefied second powder 42 seeps at least partially into a portion of first layer 32, forming an intermediate layer 45.

Figure 4 is a cross-sectional diagram of sheet of first layer 32 and second layer 40 during a subsequent stage of fabrication. As illustrated in Figure 4, the application of thermal energy 50 to upper surface 46 is discontinued after a pre-determined time, and thermal energy 50 is applied to lower surface 36. As thermal energy 50 is extracted from upper surface 46, second powder 42 begins to re-crystallize 43. Alternatively, the application of thermal energy 50 to upper surface 46 is discontinued after a pre-determined time and thermal energy 50 is not applied to lower surface 36.

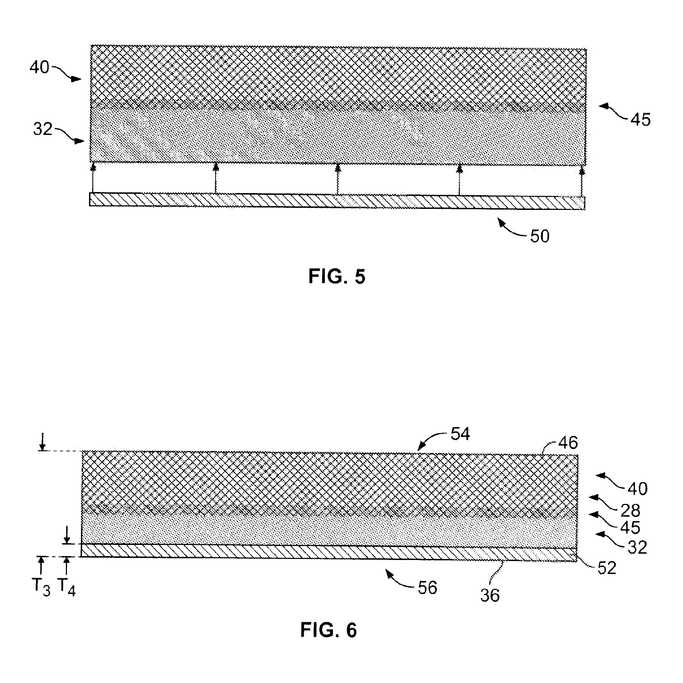

Figure 5 is a cross-sectional diagram of first layer 32 and second layer 40 during a subsequent stage of fabrication in which crystallization of second layer 40 continues. Specifically in this stage of fabrication, liquefied silicon resulting from the melting of second powder 42 continues to re-crystallize simultaneously as first powder 34 melts into a liquid. As first powder 34 melts, impurities present in first powder 34 are incorporated therein such that only trace amounts remain in the solidified fraction of second layer 40. This effectively prevents incorporation of slow diffusing elements, such as boron, into the second layer 40 so that second layer 40 remains with relatively low boron levels, and first layer 32 remains with a higher boron concentration.

Figure 6 is a cross-sectional diagram of silicon sheet 28 during a subsequent stage of fabrication. Specifically during this stage of fabrication, the application of thermal energy to lower surface 36 is discontinued after a predetermined time. Crystallization continues from upper surface 38 towards lower surface 36, and the impurities continue to settle towards lower surface 36. Specifically, a layer of impurities 52 is formed beneath surface 46. Once the crystallization of first layer 32 is complete, sheet 28 is removed from furnace apparatus 10 and a unitary body is created by intermediate layer 45.

The process and apparatus described above enable the formation of a silicon sheet from multiple layers of silicon powder having substantially similar melting points. Specifically, the silicon sheet is fabricated from a solar-grade silicon powder that contains low levels of impurities spread over a solar-grade silicon powder that contains high levels of impurities. In one embodiment, the impurities are boron and/or phosphorous.

When heat energy is applied, the top layer melts first, seeps partially into the bottom layer and is then re-crystallized. After the top layer melts, crystallization of the top layer occurs. As the top layer solidifies, impurities within the top layer segregate towards the bottom layer, effectively reducing impurities in the top of the first layer of silicon. Additionally, impurities with low diffusion constants present in the un-melted fraction of first layer 32 are not incorporated in the second layer 40 as it re-crystallizes. Heat energy is then applied to the bottom layer causing the bottom layer to liquefy. As the top layer begins to re-crystallize and the bottom layer melts, impurities are further segregated towards the bottom of the bottom layer. After the bottom layer has melted, crystallization of the bottom layer occurs. The process segregates the impurities formerly present in the top and bottom layers towards the bottom of the bottom layer. A sheet fabricated with more than one layer utilizing the method described herein enables a higher percentage of impure silicon feedstock to be utilized without adverse effect on solar cell performance than if the impure material is blended with the pure material homogeneously.

The above-described methods and apparatus provide a cost-effective and reliable means to facilitate the production of thin silicon sheets from low- cost powder silicon feedstock. Specifically, a semiconductor sheet may be fabricated from multiple layers of silicon wherein each layer is fabricated from a silicon powder having different concentrations of impurities such as boron and/or phosphorus.

Exemplary embodiments of a process and apparatus for forming a sheet of silicon using two chemically different layers of powders spread at the same time and melted is described above in detail. The process and apparatus are not limited to the specific embodiments described herein, but rather, steps of the process and components of the apparatus may be utilized independently and separately from other steps and components described herein.

While the invention has been described in terms of various specific embodiments, those skilled in the art will recognize that the invention can be practiced with modification within the spirit and scope of the claims.

Various aspects and embodiments of the present invention are now defined in the following numbered clauses:
1. A method of manufacturing a sheet of semiconductor material, said method comprising:
   forming a first layer of silicon powder, wherein the first layer has a lower surface and an opposite upper surface;
   depositing a second layer across the upper surface of the first layer, wherein the second layer of silicon powder has a melting point that is substantially similar to the melting point of the first layer of silicon powder; and
   heating at least one of the first and second layers of silicon powder to initiate a controlled melt of one of the first and second layer of silicon powder and to initiate crystallization of at least one of the first and second layers of silicon powder.
2. A method according to Clause 1, wherein forming the first layer of silicon powder further comprises forming the first layer with silicon powder that includes a plurality of impurities.
3. A method according to any preceding Clause, wherein forming the first layer of silicon powder further comprises forming the first layer with silicon powder that includes at least one of boron and phosphorous.
4. A method according to any preceding Clause, wherein forming the first layer of silicon powder further comprises forming the first layer of silicon powder with a concentration greater than about 0.5 parts per million by weight of boron and a concentration that ranges from about 1 ppm by weight to about 25 ppm by weight of phosphorous.
5. A method according to any preceding Clause, wherein forming the second layer of silicon powder further comprises forming the second layer with silicon powder that is substantially free of impurities.
6. A method according to any preceding Clause, wherein heating at least one of the first and second layers comprises applying heat to an upper surface of the second layer of silicon powder to cause the second layer of silicon powder to melt.
7. A method according to any preceding Clause, wherein heating at least one of the first and second layers further comprises applying heat to the lower surface of the first layer of silicon powder at a temperature that is substantially the same as the temperature of the heat applied to the upper surface of the second layer of silicon powder.
8. A method according to any preceding Clause, further comprising determining when the second layer of silicon powder has liquefied.
9. A method according to any preceding Clause, further comprising discontinuing heating of the second layer of silicon powder after determining that the second layer of silicon powder has liquefied.
10. A method according to any preceding Clause, wherein heating at least one of the first and second layers of silicon powder further comprises moving at least one of the first and second layers through a heating apparatus for a predetermined time.
11. A method according to any preceding Clause, further comprises cutting the sheet of semiconductor material to a desired wafer size.
12. A method of fabricating a semiconductor wafer, said method comprising:
   forming a first layer of silicon powder that has a lower surface and an opposite upper surface;
   depositing a second layer across the upper surface of the first layer, wherein the second layer of silicon powder has a lower surface and an opposite upper surface and has a substantially similar melting point to the first layer of silicon powder; and
   heating at least one of the first and second layers of silicon powder to initiate a controlled melt of one of the first and second layer of silicon powder and to initiate crystallization of at least one of the first and second layers of silicon powder.
13. A method according to Clause 12, wherein forming the first layer of silicon powder further comprises forming the first layer with the silicon powder that includes a plurality of impurities.
14. A method according to Clause 12 or 13, wherein forming the second layer of silicon powder further comprises forming the second layer with the silicon powder that is substantially free of impurities.
15. A method according to any of Clauses 12 to 14, wherein heating at least one of the first and second layers comprises applying heat to an upper surface of the second layer of silicon powder to cause the second layer of silicon powder to melt.
16. A method according to any of Clauses 12 to 15, wherein heating at least one of the first and second layers further comprises applying heat to the lower surface of the first layer of silicon powder at a temperature that is substantially the same as the temperature of the heat applied to the second layer of silicon powder.
17. A method according to any of Clauses 12 to 16, further comprising determining when the second layer of silicon powder has liquefied.
18. A method according to any of Clauses 12 to 17, further comprising discontinuing heating of the second layer of silicon powder after determining that the second layer of silicon powder has liquefied.
19. A method according to any of Clauses 12 to 18, wherein heating at least one of the first and second layers of silicon powder further comprises moving at least one of the first and second layers through a heating apparatus for a predetermined time.
20. A sheet of semiconductor material comprising a lower surface and an upper surface, said sheet of semiconductor material fabricated by a process comprising:
   forming a first layer of silicon powder that has a lower surface and an opposite upper surface;
   depositing a second layer across the upper surface of the first layer, wherein the second layer of silicon powder has a lower surface and an opposite upper surface and has a substantially similar melting point to the first layer of silicon powder; and
   heating at least one of the first and second layers of silicon powder to initiate a controlled melt of one of the first and second layer of silicon powder and to initiate crystallization of at least one of the first and second layers of silicon powder.

## Claims

1. A sheet of semiconductor material (28) comprising a lower surface and an upper surface, said sheet of semiconductor material fabricated by a process comprising:
forming a first layer (32) of silicon powder (34) that has a lower surface (36) and an opposite upper surface (38);
depositing a second layer (40) across the upper surface of the first layer, wherein the second layer of silicon powder (42) has a lower surface (44) and an opposite upper surface (46) and has a substantially similar melting point to the first layer of silicon powder; and
heating at least one of the first and second layers of silicon powder to initiate a controlled melt of one of the first and second layer of silicon powder and to initiate crystallization (43) of at least one of the first and second layers of silicon powder.

2. A sheet (28) in accordance with Claim 1, wherein the process of fabrication includes forming the first layer (32) of silicon powder further comprises forming the first layer of silicon powder with a concentration greater than about 0.5 parts per million by weight of boron and a concentration that ranges from about 1 ppm by weight to about 25 ppm by weight of phosphorous.

3. A sheet (28) in accordance with any preceding Claim, wherein the process of fabrication includes forming the second layer (40) of silicon powder further comprises forming the second layer with silicon powder that is substantially free of impurities.

4. A sheet (28) in accordance with any preceding Claim, wherein the process of fabrication includes heating at least one of the first (32) and second (40) layers comprises applying heat to an upper surface of the second layer of silicon powder to cause the second layer of silicon powder to melt.

5. A method of manufacturing a sheet of semiconductor material (28), said method comprising:
forming a first layer (32) of silicon powder (34), wherein the first layer has a lower surface (36) and an opposite upper surface (38);
depositing a second layer (40) across the upper surface of the first layer, wherein the second layer of silicon powder (42) has a melting point that is substantially similar to the melting point of the first layer of silicon powder; and
heating at least one of the first and second layers of silicon powder to initiate a controlled melt of one of the first and second layer of silicon powder and to initiate crystallization (43) of at least one of the first and second layers of silicon powder.

6. A method according to Claim 5, wherein forming the first layer (32) of silicon powder (34) further comprises forming the first layer of silicon powder with a concentration greater than about 0.5 parts per million by weight of boron and a concentration that ranges from about 1 ppm by weight to about 25 ppm by weight of phosphorous.

7. A method according to Claim 5 or 6, wherein heating at least one of the first and second layers (32,40) comprises applying heat to an upper surface of the second layer of silicon powder to cause the second layer of silicon powder to melt.

8. A method according to any of Claims 5 to 7, wherein heating at least one of the first and second layers (32,40) further comprises applying heat to the lower surface (36) of the first layer of silicon powder at a temperature that is substantially the same as the temperature of the heat applied to the upper surface of the second layer of silicon powder.
